**Europäisches Patentamt**

(19) **European Patent Office**

**Office européen des brevets**

(11) Publication number: **0 148 475**
**A2**

## (12) EUROPEAN PATENT APPLICATION

(21) Application number: **84115846.2**

(22) Date of filing: **19.12.84**

(51) Int. Cl.⁴: **H 03 K 19/013, H 03 K 19/088**

(30) Priority: **26.12.83 JP 251462/83**
**28.02.84 JP 35140/84**

(43) Date of publication of application: **17.07.85**
**Bulletin 85/29**

(84) Designated Contracting States: **DE FR GB**

(71) Applicant: **FUJITSU LIMITED, 1015, Kamikodanaka Nakahara-ku, Kawasaki-shi Kanagawa 211 (JP)**

(72) Inventor: **Tahara, Akinori, 15-25, Kotsubo 7-chome, Zushi-shi Kanagawa, 249 (JP)**
Inventor: **Kumagai, Masao, 316, Yamabukicho, Shinjuku-ku Tokyo, 162 (JP)**
Inventor: **Enomoto, Hiromu, 1-15-1225, Kawaracho Saiwai-ku, Kawasaki-shi Kanagawa, 210 (JP)**
Inventor: **Yasuda, Yasushi, 1405-5-304, Shinkoujimachi, Machida-shi Tokyo, 194-01 (JP)**

(74) Representative: **Schmidt-Evers, Jürgen, Dipl.-Ing. et al, Patentanwälte Dipl.-Ing. H. Mitscherlich Dipl.-Ing. K. Gunschmann Dipl.-Ing. Dr.rer.nat. W. Körber Dipl.-Ing. J. Schmidt-Evers Dipl.-Ing. W. Meizer Steinsdorfstrasse 10, D-8000 München 22 (DE)**

(54) **Logic circuit.**

(57) Propagation delay time of a TTL type logic circuit of a Totem pole or an open collector type having a capacitive output load ($C_L$) is reduced without increasing power consumption, and the propagation delay time is made free from stray capacitance of the output load ($C_L$) when an output level of the TTL logic circuit changes from high to low. A discharge control transistor ($Q_{15}$) is connected between an output terminal ($T_O$) and a collector of a pre-stage transistor ($Q_{11}$) for a driving transistor ($Q_{12}$) whose collector is connected the output terminal ($T_O$). The discharge control transistor ($Q_{15}$) becomes conductive and controls the driving transistor ($Q_{12}$) so as to pull down charge which has been stored in stray capacity of the output load ($C_L$) by making base current of the driving transistor ($Q_{12}$) flow more through the discharge control transistor ($Q_{15}$) and the pre-stage transistor ($Q_{11}$), in a limited time during the output of the TTL type logic circuit is changing from a high level to a low level.

December 19, 1984

TITLE OF THE INVENTION

LOGIC CIRCUIT


BACKGROUND OF THE INVENTION

The present invention relates to a logic circuit of a transistor-transistor-logic (TTL) of a Totem pole or an open collector type, more particularly, it intends to reduce a propagation delay time due to a capacitive output load when the output of the logic circuit is changed from a high (H) level to a low (L) level, with little power consumption.

The TTL type logic circuit has a function such as NAND or NOR when a positive logic or a negative logic is used respectively, and is required to be in high packing density and to operate in high speed with low power consumption. The TTL type logic circuit will be abbreviated a "TTL circuit" hereinafter. When the TTL circuit performs the above function, two kinds of propagation delay time occur, one is a delay time called a "$T_{phl}$" which occurs when the output of the TTL circuit changes from H to L level, and the other is a delay time called a "$T_{plh}$" which occurs when the output changes from L to H level. Each delay time occurs when a capacitive load like a coaxiaL cable having distributed capacity is connected to the TTL circuit, and the delay time causes to reduce the operation speed of the TTL circuit. The present invention intends to reduce the delay time "$T_{phl}$". This delay time "$T_{phl}$" can be reduced

if high power is allowed to be applied to the TTL circuit, however, it contradicts the saving of power consumption. So reducing the delay time $T_{phl}$ with little power consumption, in other words, increasing the operation speed with little power consumption has been a problem for the prior art TTL circuit. More detail will be discussed later showing typical TTL circuits of the prior art.

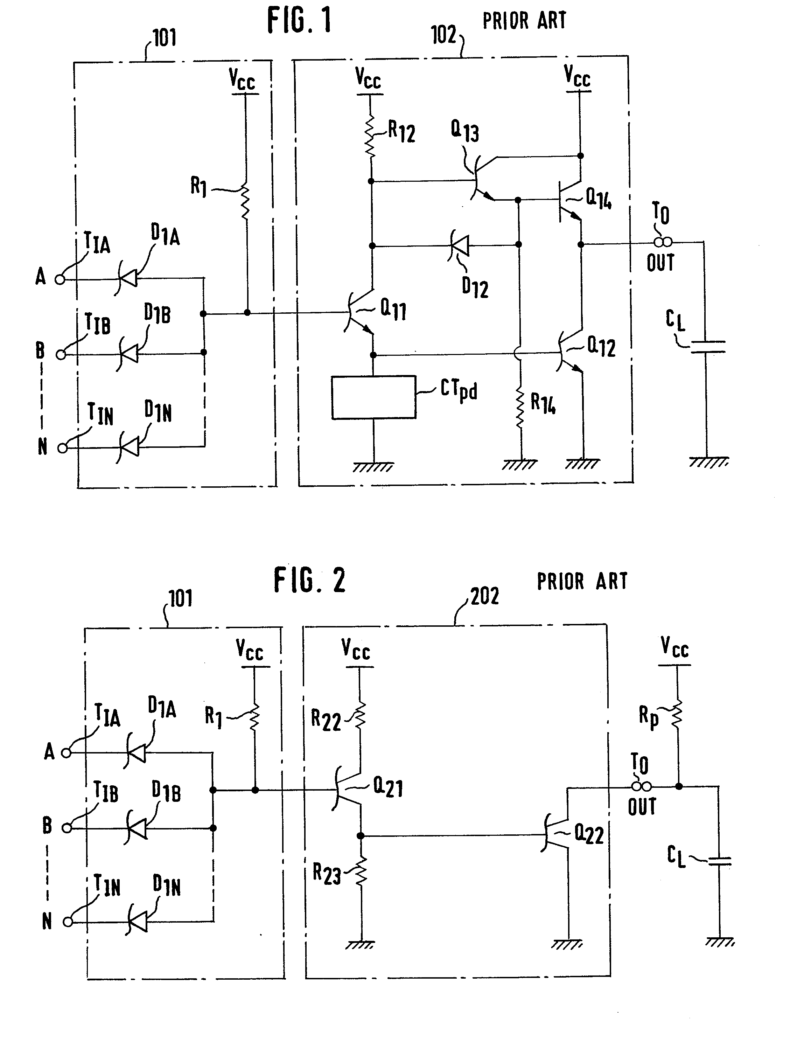

Fig. 1 shows a circuit diagram of a prior art TTL circuit of the Totem pole circuit type, and Fig. 2 shows a circuit diagram of a prior art TTL circuit of the open collector circuit type. As shown in the figures, the TTL circuit is composed of an input unit 101 and an output unit 102 or 202.

In Fig. 1, the input unit 101 in the prior art TTL circuit of the Totem pole type is composed of Shottky Barrier Diodes $D_{1A}$, $D_{1B}$, ---, $D_{1N}$ and a resistor $R_1$, and the output unit 102 is composed of a selective circuit mainly consisting of a selective transistor $Q_{11}$ and an output circuit mainly consisting of a pull up transistor $Q_{14}$ and a driving transistor $Q_{12}$, the pull up transistor $Q_{14}$ forms a Darlington connection with a transistor $Q_{13}$. The pull up transistor $Q_{14}$ and the driving transistor $Q_{12}$ are connected each other in a form of Totem pole, so the circuit of this kind is called as Totem pole type TTL circuit. Transistors $Q_{11}$, $Q_{12}$, and $Q_{13}$ are Shottky Barrier Transistors in Fig. 1.

When at least one of input logics A, B, ---, N at input terminals $T_{IA}$, $T_{IB}$, ---, $T_{IN}$ is in L level, transistor $Q_{11}$ is OFF and transistor $Q_{13}$ is ON. Then the base current of transistor $Q_{13}$ flows from a power supply ($V_{cc}$) through a resistor $R_{12}$ making transistor $Q_{14}$ ON, so an output at an output terminal $T_O$ becomes H level charging stray capacity of the capacitive load $C_L$.

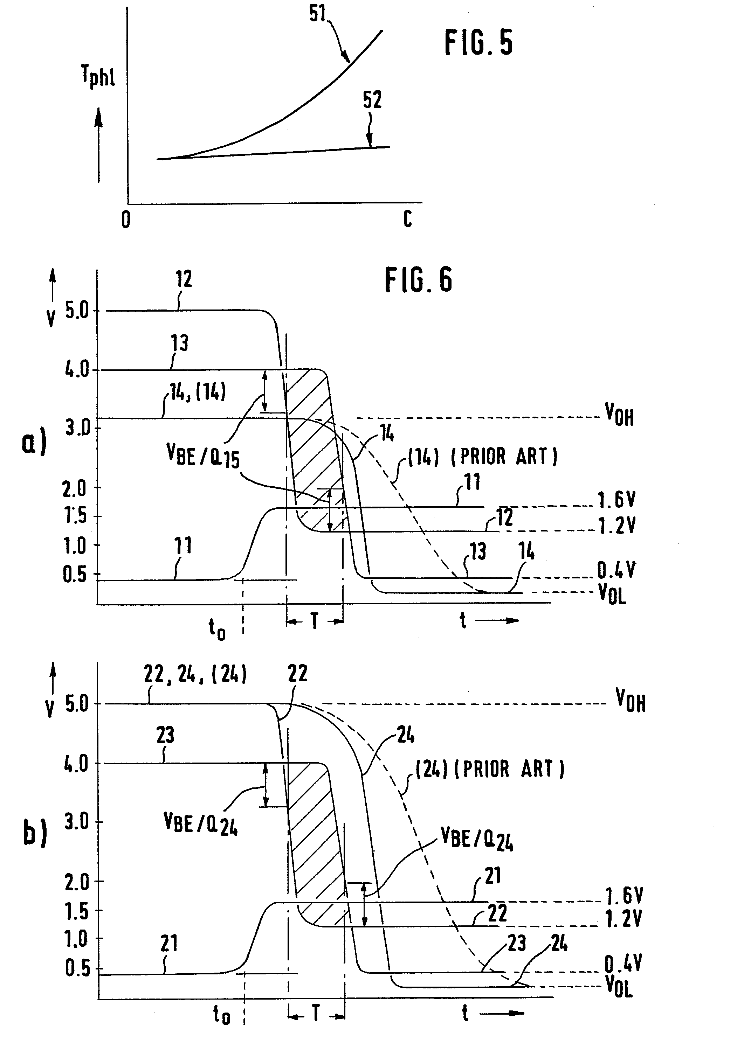

When the whole input logics change to H level, transistor $Q_{11}$ becomes ON and transistor $Q_{13}$ becomes OFF. So an Shottky barrier diode $D_{12}$ makes charge having been stored on stray capacity around emitter circuit of transistor $Q_{13}$ discharge, and makes transistor $Q_{14}$ OFF rapidly. Then, the discharge current which flows through diode $D_{12}$, the collector current of transistor $Q_{11}$ which flows through resistor $R_{12}$, and the base current of transistor $Q_{11}$ are gathered together forming the emitter current of transistor $Q_{11}$. The emitter current flows to ground through a pull down circuit $CT_{pd}$ and the base - emitter of the driving transistor $Q_{12}$ separately, and most of the emitter current flow through the base-emitter junction of transistor $Q_{12}$ because the impedance of the base - emitter of $Q_{12}$ is much smaller than that of $CT_{pd}$. As a result, the pull up transistor $Q_{14}$ becomes OFF and the driving transistor $Q_{12}$ becomes ON, so that the output at the output terminal $T_O$ changes from H to L level. Then, the charge having been stored in stray capacity of the capacitive load $C_L$ is discharged through transistor $Q_{12}$,

and the output voltage is pulled down to ground, but it takes a time to complete the operation, this time is the delay time $T_{ph1}$ which depends on capacitance of load $C_L$, characteristics of transistor $Q_{12}$ such as a current amplification factor, and the base current of transistor $Q_{12}$. However the base current of transistor $Q_{12}$ is constant, in other words, the base current has no relation to the capacitance of load $C_L$. So, though the stray capacitance increases, the base current is not influenced, and it is always constant, therefore, the increase of the stray capacitance increases the delay time $T_{ph1}$ as shown by a curve 51 in Fig. 5, in which C is the stray capacitance of the capacitive load $C_L$. This means that the delay time $T_{ph1}$ of the TTL circuit strongly depends on the stray capacitance of the capacitive load. If the base current of transistor $Q_{12}$ was allowed to be increased, the delay time $T_{ph1}$ could be reduced, however, this contradicts the saving of power consumption in the TTL circuit.

In Fig. 2, the same reference symbol or numeral to that used in Fig. 1 designates the same unit or element, and a unit 202 is also an output unit. The input unit 101 is composed of the same elements of that shown in Fig. 1, and unit 202 is composed of a phased splitter transistor $Q_{21}$ and a driving transistor $Q_{22}$. In this TTL circuit, Shottky barrier diodes and Shottky barrier transistors are used for respective diodes and transistors. As the TTL circuit is an open collector type, a collector resistor $R_p$,

which is usually called a "pull up resistor", is not included in the TTL circuit.

When at least one of input logics A, B, ---, N is L level, transistor $Q_{21}$ is OFF, so transistor $Q_{22}$ is also OFF. Therefore, the stray capacity of load $C_L$ is charged up by the power supply ($V_{cc}$) through resistor $R_p$.

When the whole input logics change to H level, transistor $Q_{21}$ becomes ON, so transistor $Q_{22}$ also becomes ON. Therefore, the charge stored in the stray capacity of load $C_L$ is discharged to ground through transistor $Q_{22}$. In this case, the same problem to that in the Totem pole type occurs. That is, when the output voltage at the output terminal $T_O$ changes from H to L level, it takes the propagation delay time $T_{phl}$, because base current of transistor $Q_{22}$ has no relation to $T_{phl}$ and the base current can not be increased for saving the power consumption of the TTL circuit. Thus, also in this case, the propagation delay time $T_{phl}$ strongly depends on the stray capacitance of load $C_L$ in the open collector type TTL circuit as shown by curve 51 in Fig. 5. As a result, it has been impossible to shorten the propagation delay time which occurs when the output of the TTL circuit changes from H to L level with little power consumption in the prior art TTL circuits of the Totem pole type and the open collector type. This has been a problem of the prior art TTL circuit.

## SUMMARY OF THE INVENTION

An object of the present invention is to reduce the propagation delay time produced in the TTL circuit having a capacitive load when an output of the TTL circuit changes from a high level to a low level.

Another object of the present invention is to make the propagation delay time free from an amount of stray capacitance distributed on the capacitive load.

Still another object of the present invention is to save power consumption in the TTL circuit for reducing the propagation delay time.

The present invention can be applied to the TTL circuit of such as a Totem pole type or an open collector type.

The present invention can be performed by increasing base current of a driving transistor which is the last output stage in the TTL circuit only in a transient time when the output of the TTL circuit is changing from a high level to a low level, applying circuit elements such as diodes and transistors between the last driving transistor and its pre-stage transistor whose emitter is connected to the base of the driving transistor. The applied circuit elements feed back quickly a part of discharge current from the stray capacity of the capacitive load to the base of the driving transistor in the transient time, so that the propagation delay time can be reduced in a short time, saving the power consumption in the TTL circuit.

## BRIEF DESCRIPTION OF THE DRAWINGS

Fig. 1 is a circuit diagram of a typical prior art TTL circuit of a Totem pole type;

Fig. 2 is a circuit diagram of a typical prior art TTL circuit of an open collector type;

Fig. 3 is a circuit diagram for an embodiment of the present invention having a Totem pole type TTL circuit;

Fig. 4 is a circuit diagram for another embodiment of the present invention having an open collector type TTL circuit;

Fig. 5 is a graph showing relation between value of stray capacitance in a capacitive load and propagation delay time comparing with the TTL circuits of the prior art and that of the present invention; and

Fig. 6 are level graphs showing voltage levels at designated points in the Totem pole type and the open collector type TTL circuits of the present invention when the output of each TTL circuit changes from a high level to a low level, Fig. 6 (a) and (b) for the Totem pole type and the open collector type respectively, each of which has partially an output level of the prior art for comparing with that of the present invention.

## DETAILED DESCRIPTION OF THE INVENTION

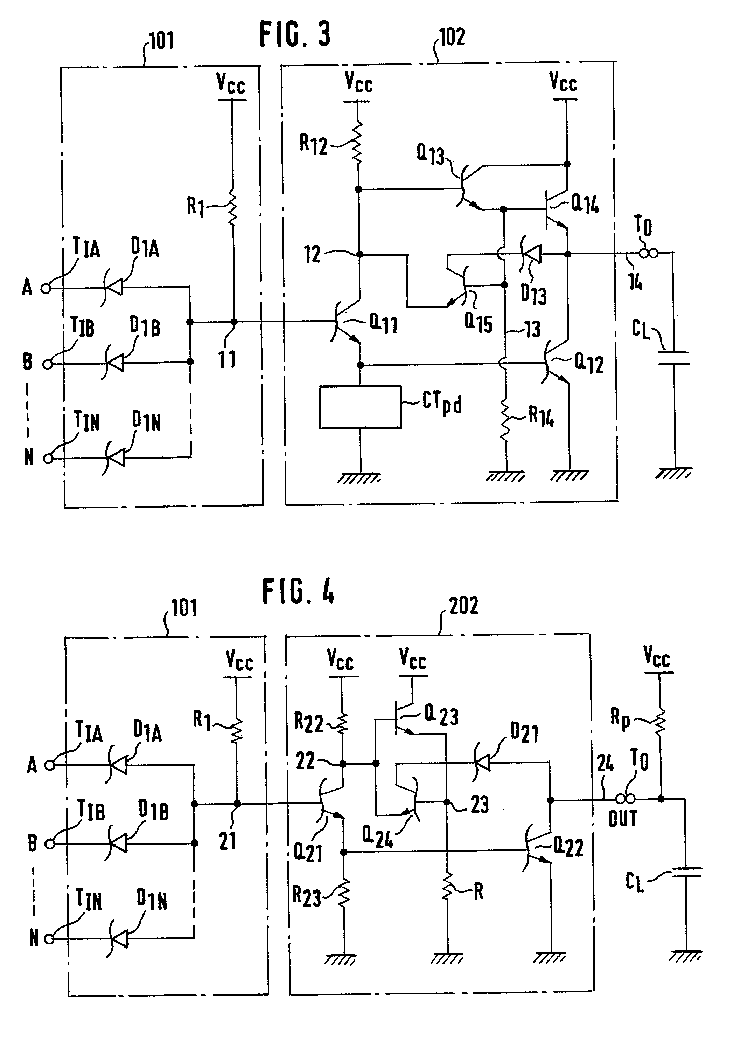

Fig. 3 shows an embodiment for a Totem pole type TTL circuit of the present invention. In the figure, the same reference symbol or numeral to that used in Fig. 1 designates the same unit or element. As shown in the figure, the TTL circuit is provided with additional discharge control transistor $Q_{15}$ made of a Shottky barrier transistor having a reverse current blocking diode $D_{13}$ made of a Shottky barrier diode compared with the prior art TTL circuit of Fig. 1.

When at least one of the input logics A, B, ---, N is in L level, the selective transistor $Q_{11}$ is OFF, so the transistor $Q_{13}$ which is connected to the transistor $Q_{14}$ forming the Darlington connection is ON, the pull up transistor $Q_{14}$ is ON. So, transistor $Q_{15}$ is OFF because its emitter voltage is high compared with its base voltage. As a result, collector current of transistor $Q_{14}$ charges the stray capacity of the capacitive load $C_L$ and the output at the output terminal $T_O$ is kept in H level. Then, when all input logics changes to H levels, transistors $Q_{11}$ and $Q_{13}$ become OFF and ON respectively, transistor $Q_{14}$ becomes OFF, and transistor $Q_{15}$ becomes ON because its emitter voltage is lowered. So transistor $Q_{15}$ discharges the charge stored in stray capacity around circuits of the emitter of transistor $Q_{13}$ and the base of transistor $Q_{14}$ flow through its base-emitter junction, for making transistor $Q_{14}$ OFF rapidly, and the collector current of transistor $Q_{15}$ pulls a part of the charge stored in the stray capacity of load $C_L$ down to the collector of transistor $Q_{11}$ through diode $D_{13}$. The base current and the collector current of transistor $Q_{15}$ flow through transistor

$Q_{11}$ and most of them flow through the base-emitter junction of the driving transistor $Q_{12}$. This increased base current of transistor $Q_{12}$ drives transistor $Q_{12}$ to make its collector current flow more, so that the charge having been stored in the stray capacity of load $C_L$ can be rapidly discharged. This means that the base current of the driving transistor $Q_{12}$ depends on an amount of the charge stored in the capacitive load $C_L$, in other word, the driving transistor $Q_{12}$ can pull down the charge according to the amount of the stray capacitance of load $C_L$. As a result, the relation between the stray capacitance C and the propagation delay time $T_{ph1}$ is decreased as shown by curve 52 in Fig. 5. The curve shows that the propagation delay time $T_{ph1}$ can be shortened independently of the amount of the stray capacitance C, in other words, the propagation delay time can be made free from the stray capacitance of the capacitive load.

Figure 6 (a) shows voltage levels at main points in the TTL circuit of Fig. 3. In the figure, reference numeral 11 is a voltage level at the base of the selective transistor $Q_{11}$ and numeral 12 is that at its collector, numeral 13 is that at the base of transistor $Q_{15}$, and numeral 14 is that at the output terminal $T_O$. The abscissa is time and the ordinate is the voltage level. At the beginning of time in the figure, at least one of the input logics is in L level, and the all input levels change to H at time $T_O$. For example, before time $t_O$, the level 11 is 0.4 volt (V) because of voltage drop by the current which flows through resistor $R_1$ and diodes $D_{1A}$, $D_{1B}$, ---, $D_{1N}$, the level 12 is approximately 5 V because transistor $Q_{11}$ is OFF and only few base current of transistor $Q_{13}$ flows, the level 13 is 4 V because of the base-emitter voltage drop by the base-emitter current of transistor $Q_{13}$, and the level 14 is 3.2 V because of the voltage drop by leakage current which flows through the Darlington connected transistors $Q_{13}$ and $Q_{14}$, the leakage current is inevitable for the TTL circuit, and the capacitive load $C_L$ and the voltage of the level 14 is high level output voltage called $V_{OH}$. At the time $t_O$, the level 11 rises up to 1.6 V, so the level 12 falls down to 1.2 V a little late from $t_O$, then the level 13 also falls down to 0.4 V with a little delay. When the levels 12 and 13 are falling down respectively, transistor $Q_{15}$ begins to make its collector current flow when the voltage difference between the levels 12 and 13 exceeds base-emitter threshold voltage $V_{BE/Q15}$ of transistor $Q_{15}$, and the flow of the collector current of $Q_{15}$ ends when the voltage difference becomes less than the threshold voltage $V_{BE/Q15}$. An extent of a hatched zone in Fig. 6 (a) indicates a conductive zone of transistor $Q_{15}$, and T is a time interval in which transistor $Q_{15}$ is conductive. The driving transistor $Q_{12}$ runs much collector current, so the level 14 falls down to $V_{OL}$ from $V_{OH}$ in a short time as shown in the figure, where $V_{OL}$ is the output voltage in L level. A dotted line (14) is the output level of the prior art TTL circuit for comparison.

Consequently, the propagation delay time can be shortened as shown by the falling part of the level 14 and only little power consumption is required to obtain the short propagation delay time as shown by the hatched zone or the time interval T in Fig. 6 (a).

Fig. 4 shows an embodiment for an open collector type TTL circuit of the present invention. In the figure, the same symbol or numeral to that used in Fig. 2 designates the same unit or element. The TTL circuit is provided with additional second discharge control transistor $Q_{23}$, a first discharge control transistor $Q_{24}$ made of a Shottky barrier transistor, and a reverse current blocking diode $D_{21}$ made of a Shottky barrier diode compared with the prior art TTL circuit of Fig. 2. Fig. 6 (b) shows voltage levels at points 21, 22, 23, and 24; each point is as shown in Fig. 4.

When at least one of the input logics is L level, the level 21 at the base of the phased splitter transistor $Q_{21}$ is 0.4 V because of a voltage drop by the current which flows through resistor $R_1$ and diodes $D_{1A}$, $D_{1B}$, ---, $D_{1N}$, and transistor $Q_{21}$ is OFF, so no base current flows through the base-emitter junction of the driving transistor $Q_{22}$, so that transistor $Q_{22}$ is OFF. Therefore, stray capacity in the capacitive load $C_L$ is charged through the pull up resistor $R_p$, and the level at the output terminal $T_O$ is 5 V; this level is called $V_{OH}$. On the other hand, the level 22 at the collector of transistor $Q_{21}$ rises up to approximately 5 V being $V_{cc}$, so transistor $Q_{23}$ is ON and the base-emitter voltage drop by its base-emitter base current produces the level 23 so as to be 4 V. However, transistor $Q_{24}$ is OFF because its emitter voltage is 5 V (the level 22) and its base voltage is 4 V (the level 23) causing no base current to flow.

Then next, when the input logics are changed so that the all logics become H levels at time $t_0$, the level 21 rises up to 1.6 V because voltage drop of resistor $R_1$ from $V_{cc}$ by the base current of transistor $Q_{21}$, transistor $Q_{21}$ becomes ON, so the level 22 begins to fall down a little late from time $t_0$ to 1.2 V finally. During the level 22 is falling down, the level 23 at the base of transistor $Q_{24}$ begins to fall further a little later to the fall off level 22, so there is time when the base-emitter voltage of transistor $Q_{24}$ exceeds its threshold voltage $V_{BE/Q24}$, so transistor $Q_{24}$ begins to make its collector current flow through diode $D_{21}$ provided to block a reverse current flow through transistor $Q_{24}$. This collector current flows untill when the base-emitter voltage becomes less than the threshold voltage. An extent of a hatched zone in Fig. 6 (b) shows a conductive zone of transistor $Q_{24}$, and a time interval T is an interval in which transistor $Q_{24}$ is conductive. During the time interval T, current which flows through resistor $R_{22}$, the base and collector current of transistor $Q_{24}$, and also the base current of transistor

$Q_{21}$ are gathered to form the emitter current of transistor $Q_{21}$. Most of the emitter current flow into the base – emitter of the drive transistor $Q_{22}$, which rapidly pulls down most of the charge have been stored in the stray capacity of the capacitive load $C_L$.

Thus the driving transistor $Q_{22}$ pulls down most of the discharge current from load $C_L$ in the time interval T, which means that the TTL circuit saves the power consumption. And when the stray capacitance of load $C_L$ increases, the collector current of transistor $Q_{24}$ also increases, then the base current of transistor $Q_{22}$ increases, so that transistor $Q_{22}$ makes the discharging current flow more, which means that the propagation delay time $T_{ph1}$ can be made free from an amount of the capacitance of the capacitive load $C_L$ as shown by curve 52 in Fig. 5, and the propagation delay time can be shortened as shown by the levels 24; the level 24 falls down from $V_{OH}$ to $V_{OL}$ in short time comparing with the level (24) which is the level at the output terminal $T_O$ obtained by the prior art TTL circuit.

Consequently, the propagation delay time can be reduced, the propagation delay time can be made free from the capacitance of the output load, and the power consumption of the TTL circuit can be saved, by the Totem pole type and the collector open type TTL circuits of the present invention.

What is claimed is:

CLAIMS
===========

1. A logic circuit, characterized in an input unit (101) for providing an output level being high or low receiving at least one input logic whose level being high or low; and an output unit (102) for providing an output of said logic circuit so that a level of said output is high or low receiving said output level of said input unit, said output unit (102) further comprising: a driving transistor ($Q_{12}$, $Q_{22}$) connected to an output terminal($T_O$) of said logic circuit, said output terminal ($T_O$) being connected to an output load ($C_L$), for pulling down the output level of said logic circuit from high to low; a pre-stage transistor ($Q_{11}$, $Q_{21}$) connected between said driving transistor ($Q_{12}$, $Q_{22}$) and said input unit (101), for controlling said driving transistor ($Q_{12}$, $Q_{22}$) according to said output level of said input unit (101); and a discharge control transistor ($Q_{15}$, $Q_{23}$, $Q_{24}$) connected between said output terminal ($T_O$) and said pre-stage transistor ($Q_{11}$, $Q_{21}$), for controlling said driving transistor ($Q_{11}$, $Q_{21}$) so as to discharge the charge having been stored in the stray capacity of said output load ($C_L$), while the output level of said logic circuit is changing from high to low.

2. A logic circuit according to claim 1, characterized in that said logic circuit is a Totem pole type circuit having a pull up transistor ($Q_{13}$, $Q_{14}$) connected to said driving transistor ($Q_{12}$) in series, and a collector of said driving transistor ($Q_{12}$) is connected to said output terminal and to an emitter of said pull up transistor ($Q_{13}$, $Q_{14}$), and a base of said driving transistor ($Q_{12}$) is connected to an emitter of said pre-stage transistor ($Q_{11}$);

said pre-stage transistor is a selective transistor ($Q_{11}$), and a collector of said selective transistor ($Q_{11}$) is connected to an emitter of said discharge control transistor ($Q_{15}$) and to a base of a transistor ($Q_{13}$) whose emitter is connected to a base of said pull up transistor ($Q_{14}$) forming a Darlington connection, and a base of said selective transistor ($Q_{11}$) is connected to said input unit (101); and

a collector of said discharge control transistor ($Q_{15}$) is connected to said output terminal ($T_O$) through a current blocking diode ($D_{13}$), and a base of said discharge control transistor ($Q_{15}$) is connected to the emitter of said transistor ($Q_{13}$) connected to said pull up transistor ($Q_{14}$).

3. A logic circuit according to claim 1, characterized in that said logic circuit is an open collector type circuit, and

a collector of said driving transistor ($Q_{12}$) is connected to said output terminal ($T_O$), and a base of said driving transistor ($Q_{22}$) is connected to an emitter of said pre-stage transistor ($Q_{21}$); ·

said pre-stage transistor is a phased splitter transistor ($Q_{21}$), and its base is connected to said input unit (101); and

said discharge control transistor comprises a first discharge control transistor ($Q_{24}$) and a second discharge

control transistor ($Q_{23}$), a collector of said first discharge control transistor ($Q_{24}$) is connected to said output terminal ($T_O$) through a current blocking diode ($D_{21}$), an emitter of said first discharge control transistor ($Q_{24}$) is connected to a collector of said phased splitter transistor ($Q_{21}$), a base of said first discharge control transistor ($Q_{24}$) is connected to an emitter of said second discharge control transistor ($Q_{23}$), and a base of said second discharge control transistor ($Q_{23}$) is connected to the collector of said phased splitter transistor ($Q_{21}$).

4. A logic circuit according to any one of claims 1 - 3, characterized in that the transistors are Shottky Barrier Transistors and the diode is a Shottky Barrier Diode.

0148475

## FIG. 1 PRIOR ART

## FIG. 2 PRIOR ART

## FIG. 3

## FIG. 4

0148475

FIG. 5

FIG. 6